(19) Europäisches Patentamt
European Patent Office
Office européen des brevets

(11) Veröffentlichungsnummer: **0 033 990**
**B1**

(12) **EUROPÄISCHE PATENTSCHRIFT**

(45) Veröffentlichungstag der Patentschrift: **01.08.84**

(51) Int. Cl.³: **C 30 B 29/22**, C 30 B 15/00, H 01 F 10/20

(21) Anmeldenummer: **81200099.0**

(22) Anmeldetag: **28.01.81**

(54) **Magnetische Anordnung.**

(30) Priorität: **12.02.80 DE 3005195**
**12.02.80 DE 3005219**

(43) Veröffentlichungstag der Anmeldung:
**19.08.81 Patentblatt 81/33**

(45) Bekanntmachung des Hinweises auf die Patenterteilung:
**01.08.84 Patentblatt 84/31**

(84) Benannte Vertragsstaaten:
**CH DE FR GB IT LI**

(56) Entgegenhaltungen:
**US - A - 3 638 207**

**NATURWISSENSCHAFTEN, Band 66, 1979 F. HABEREY: "Zur Züchtung von SrGa12019-Einkristallen", Seite 617**

(73) Patentinhaber: **Philips Patentverwaltung GmbH, Billstrasse 80, D-2000 Hamburg 28 (DE)**
(84) Benannte Vertragsstaaten: **DE**

(73) Patentinhaber: **N.V. Philips' Gloeilampenfabrieken, Groenewoudseweg 1, NL-5621 BA Eindhoven (NL)**
(84) Benannte Vertragsstaaten: **CH FR GB IT LI**

(72) Erfinder: **Mateika, Dieter, Dr., Seerosenstrasse 16, D-2081 Ellerbek (DE)**
Erfinder: **Bartels, Günter, Am Wall 5, D-2080 Pinneberg (DE)**

(74) Vertreter: **Nehmzow-David, Fritzi-Maria et al, Philips Patentverwaltung GmbH**
***Billstrasse 80 Postfach 10 51 49,***
**D-2000 Hamburg 28 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 033 990 B1**

**Beschreibung**

Die Erfindung betrifft eine magnetische Anordnung mit einem monokristallinen, nichtmagnetischen Substrat, das eine zum Niederschlagen einer Schicht bestimmte Oberfläche hat und mit einer monokristallinen, magnetischen Schicht aus hexagonalem Hexaferritmaterial.

Hexagonale, monokristalline dünne Ferritschichten, z.B. von der einfachen Formel $BaO \cdot 6Fe_2O_3$ auf unmagnetischen Substraten könnten aufgrund ihrer sehr grossen uniaxialen Anisotropie und ihrer kleinen Linienbreite eine hervorragende Bedeutung als passive Mikrowellenbauelemente, z.B. als Resonanzisolatoren oder Filter im Zentimeterwellenbereich oder als Bauelement in der Informationsspeichertechnik, z. B. in magnetischen Zylinderdomänenanordnungen insbesondere im Bereich sehr kleiner (submicron)-Zylinderdomänen haben. Magnetische Granatschichten, die z.B. in der Informationsspeichertechnik angewendet werden, können bekanntlich bei Frequenzen $>50$ GHz nicht mehr eingesetzt werden. Um monokristalline Ferritschichten in einer Qualität, Homogenität und Kristallperfektion, wie sie z.B. von Bauelementen für ähnliche Anwendungszwecke mit magnetischen Granatschichten her bekannt ist, herstellen zu können, bedarf es jedoch eines Substrateinkristalls, der nicht nur eine ähnliche chemische Zusammensetzung wie die der auf ihm zu züchtenden Schicht hat, sondern der Substrateinkristall muss eine gleiche kristallographische Struktur und eine nahezu gleiche Gitterkonstante wie die auf ihm anzubringende Schicht besitzen.

Es wurde versucht, hexagonale monokristalline Ferritschichten, z.B. der Zusammensetzung $Ba_2Zn_2Fe_{12}O_{22}$ auf hexagonalen Ferritsubstraten der Zusammensetzung $BaFe_{12}O_{19}$ durch Flüssigphasenepitaxie zu züchten (Mat. Res. Bull. 10 (1975) S. 1255–1258). Befriedigende Ergebnisse wurden mit diesen Substraten nach Aussage der Arbeit nicht erzielt (vgl. Seite 1255, letzter Absatz, bis Seite 1256, 1. Absatz).

Es wurde weiter versucht, hexagonale monokristalline Ferritschichten, z.B. vom Typ $BaO \cdot 6Fe_2O_3$ auf unmagnetischen Spinellsubstraten der Zusammensetzung $ZnGa_2O_4$ oder $Mg(In, Ga)_2O_4$ mittels Epitaxie zu züchten, doch auch diese Versuche scheiterten, die Schichten wuchsen nicht einwandfrei auf, sondern bildeten Inseln auf den zu beschichteten Substratoberflächen (vgl. J. Appl. Phys. 49 (1978), Nr. 3, S. 1578-1580).

Für alle magnetischen Anwendungen ist es Voraussetzung, ein nichtmagnetisches Substrat zu verwenden, da magnetische Substrate die magnetischen Eigenschaften der mit ihnen erstellten Bauelemente durchaus nachteilig beeinflussen.

Bislang war es nicht möglich, einkristalline hexagonale Hexaferritschichten in guter Qualität, Homogenität und Kristallperfektion herzustellen, weil kein geeignetes Substrat als Keimunterlage vorlag.

Der Erfindung liegt die Aufgabe zugrunde, eine magnetische Anordnung mit einer magnetischen monokristallinen hexagonalen Hexaferritschicht auf einem monokristallinen, michtmagnetischen Substrat zu schaffen, bei welcher die magnetische Dünnschicht in einer solchen Qualität und Kristallperfektion vorhanden ist, die der Qualität von magnetischen Granatschichten entspricht.

Diese Aufgabe wird erfindungsgemäss dadurch gelöst, dass das Substrat aus einem Erdalkali-Gallat-Mischkristall der allgemeinen Formel

$$A^{2+}_{1+y}Ga_{12-2x-y}B^{2+}_{x}C^{4+}_{x}O_{19}$$

besteht, wobei in der Formel bedeuten:

A = Barium und/oder Strontium

B = Magnesium und/oder Mangan und/oder Zink und/oder Eisen und/oder Kupfer und/oder Nickel und/oder Kobalt und/oder Chrom

C = Zirkonium und/oder Hafnium und/oder Titan und/oder Zinn

und $0{,}1 \leqq x \leqq 1{,}2$ und $0 \leqq y \leqq 0{,}8$.

Vorzugsweise beträgt $0{,}4 \leqq x \leqq 0{,}8$.

Nach einer vorteilhaften Weiterbildung der Erfindung weist die zum Niederschlagen einer Schicht bestimmte Oberfläche des Substrates eine Orientierung in [0001]-Richtung auf und hat eine Abweichung von der idealen Richtung der c-Achse im Bereich von 1 bis 2°.

Es wurde die Erkenntnis gewonnen, dass bei einer Abweichung von der idealen Richtung der c-Achse in dieser Grössenordnung die qualitativ besten Schichten aufwachsen. Bei einer höheren Abweichung von der idealen Richtung der c-Achse (5 bis 10°) bildet sich treppenartiges Wachstum der monokristallinen Schichten auf dem Substrat aus, während bei exakter c-Orientierung der Substrate ein inselartiges Wachstum der Schichten zu beobachten ist.

Nach einer weiteren vorteilhaften Ausgestaltung der Erfindung liegt die Schichtdicke der monokristallinen magnetischen Schicht im Bereich von 0,5 bis 10 µm. Es ist wichtig, dass die Schichtdicke nicht grösser als 10 µm ist, weil bei grösserer Schichtdicke ein Abplatzen der Schicht vom Substrat zu beobachten ist. Möglicherweise ist dies auf die leichte Spaltbarkeit des Schichtmaterials senkrecht zur Richtung der c-Achse zurückzuführen.

Ein Verfahren zum Herstellen einer magnetischen Anordnung gemäss der Erfindung wird vorteilhafterweise so ausgeführt, dass die Ausgangssubstanzen für den Substateinkristall zunächst trocken verpresst und bei 1500°C 12 bis 30 h in Sauerstoffatmosphäre gesintert werden, dass der Sinterkörper zur Herstellung eines Einkristalls nach dem Czochralski-Verfahren in einer abgeschlossenen Kristallziehapparatur bei $\sim 1600$°C aufgeschmolzen wird, dass aus dieser Schmelze ein Einkristall mit Hilfe eines Keimkristalls mit einer Wachstumsgeschwindigkeit von 1 bid 2mmh$^{-1}$ bei einer Rotationsgeschwindigkeit des Keimkristalls von 5 bis 20 Umin$^{-1}$ gezogen

wird, dass von diesem Einkristall Scheiben einer Dicke von 0,5 bis 1 mm mit einer Orientierung in [0001]-Richtung und einer Abweichung von 1 bis 2° von der idealen Richtung der c-Achse abgeschnitten und poliert werden und dass auf mindestens eine der Substratscheibenflächen eine monokristalline Schicht aus hexagonalem Hexaferritmaterial epitaktisch aufgebracht wird.

Nach einer weiteren Ausgestaltung der Erfindung wird als Ausgangsmaterial für die Schmelze, aus der der Substrateinkristall gemäss Anspruch 3 nach dem Czochralski-Verfahren unter $CO_2$-Atmosphäre gezogen wird, eine Mischung von 77,87 g SrO, 481,97 g $Ga_2O_3$, 9,90 g MgO und 30,26 g $ZrO_2$ aufgeschmolzen.

Nach einer weiteren Ausgestaltung der Erfindung wird als Ausgangsmaterial für die Schmelze, aus der der Substrateinkristall gemäss Anspruch 4 nach dem Czochralski-Verfahren unter einem Druck von 1 bar $O_2$ und 5 bar $N_2$ gezogen wird, eine Mischung von 19,28 g $SrCO_3$, 112,39 g $Ga_2O_3$, 9,79 g ZnO und 14,84 g $ZrO_2$ aufgeschmolzen.

Die magnetische Schicht wird auf das unmagnetische Substrat vorteilhafterweise durch Flüssigphasenepitaxie aufgebracht.

Die mit der Erfindung erzielten Vorteile bestehen insbesondere darin, dass nunmehr ein Substratmaterial geschaffen ist, mit dem es möglich ist, einwandfreie Schichten von hexagonalen Hexaferriten, z.B. Bariumhexaferrit, in guter Qualität, Homogenität und Kristallperfektion auf nichtmagnetische Substrate monokristallin aufzubringen. Ein weiterer mit dem Verfahren zur Herstellung der magnetischen Anordnung gemäss der Erfindung verbundener Vorteil ist, dass Einkristalle von einer Länge gezüchtet werden können, die die Herstellung einer ausreichenden Anzahl von Substratscheiben aus einem Einkristall ermöglicht, wobei infolge des relativ grossen Durchmessers des gezüchteten Substrateinkristalls auch Substratscheiben erhalten werden können, die für eine industrielle Anwendung gross genug sind.

Mit der Züchtung von Erdalkali-Gallat-Einkristallen sind Schwierigkeiten verknüpft. Bekannt sind die T-x-Phasendiagramme der Systeme $BaO/Ga_2O_3$ und $SrO/Ga_2O_3$ (vgl. P. Batti, G. Sloccari Ann. Chim. 59 (1969) S. 155-162; L.M. Korba et al., Russian J. of Inorganic Chemistry 20 (1975) 7; V.P. Kobzareva et al., Russian J. of Inorganic Chemistry 21 (1976) 6.). Hiernach schmelzen die Verbindungen $BaGa_{12}O_{19}$ und $SrGa_{12}O_{19}$ inkongruent. Als erste Phase aus stöchiometrischen Schmelzen kristallisiert $Ga_2O_3$. Eine Züchtung aus der eigenen Schmelze ist daher nicht möglich. Darüberhinaus ist das Zustandsfeld beider Verbindungen nach dem Phasendiagramm sehr eng. So kristallisiert z.B. Strontiumgallat aus Schmelzen im Konzentrationsbereich von ca. 32 Mol.% SrO und 68 Mol.% $Ga_2O_3$ bis 36 Mol.% SrO und 64 Mol.% $Ga_2O_3$. Der Kristall hat das Molverhältnis 14 Mol.% SrO und 86 Mol.% $Ga_2O_3$. Aus diesem Grund scheidet eine Züchtung des Einkristalls entlang der Liquiduskurve aus nichtstöchiometrischen Schmelzen ebenfalls aus; dies ist durch Versuche bestätigt worden. Für die Einkristallzüchtung von Erdalkali-Gallaten, wie z.B. $SrGa_{12}O_{19}$ sind das enge Zustandsfeld und der grosse Überschuss an SrO (18 Mol.%), bzw. das Defizit an $Ga_2O_3$ in der Schmelze im Vergleich zur kristallisierenden Verbindung die entscheidenden Hindernisse.

Überraschenderweise wurde gefunden, dass eine hexagonale Erdalkali-Gallat-Phase aus der Schmelze hergestellt werden kann, wenn die Galliumionen der hexagonalen Verbindung teilweise durch andere Ionen, insbesondere zwei- und vierwertige Ionen, ersetzt werden. Diese Substitution der Galliumionen ist darüberhinaus auch wichtig zur Anpassung der Gitterkonstante des Substrates an die der magnetischen Schicht.

An vier Beispielen wird nachfolgend gezeicgt, wie durch Substitution der Galliumionen der Überschuss an SrO in der Schmelze abgebaut werden kann. Bei den nachfolgend aufgeführten Schmelzzusammensetzungen 1 bis 4 resultieren die ebenfalls nachfolgend aufgeführten Kristallzusammensetzungen:

Schmelzzusammensetzung

1. $Sr_{2,48}Ga_{10,52}O_{18,26}$
2. $Sr_{1,53}Ga_{10,47}Mg_{0,5}Zr_{0,5}O_{18,75}$
3. $Sr_{1,085}Ga_{9,915}MnZrO_{18,96}$
4. $Sr_{1,085}Ga_{9,915}ZnZrO_{18,96}$

Kristallzusammensetzung

1. $SrGa_{12}O_{19}$
2. $Sr_{1,03}Ga_{10,99}Mg_{0,49}Zr_{0,49}O_{18,99}$
3. $Sr_{1,0}Ga_{10,6}Mn_{0,7}Zr_{0,7}O_{19}$
4. $Sr_{1,0}Ga_{10,38}Zn_{0,81}Zr_{0,81}O_{19}$

Der SrO-Überschuss von 1,48 pro Formeleinheit in nicht substituierten Schmelzen (Beispiel 1) kann durch die gekoppelte Substitution der Galliumionen bis auf 0,085 pro Formeleinheit abgebaut werden (Beispiel 4). Erst hierdurch wird das Einkristallwachstum von Erdalkali-Gallat-Mischkristallen aus der Schmelze möglich.

Anhand der Zeichnung wird ein Ausführungsbeispiel der Erfindung beschrieben und ihre Wirkungsweise erläutert.

Es zeigt

Fig. 1 eine magnetische Anordnung gemäss der Erfindung als Zylinderdomänenanordnung in perspektivischer Draufsichtdarstellung.

Auf einem unmagnetischen hexagonalen 0,5 mm dicken Substrat 1 aus einem Erdalkali-Gallat-Einkristall ist durch Epitaxie eine monokristalline hexagonale magnetische 10 µm dicke Hexaferritschicht 2 gezüchtet, in welche durch Anlegen eines Magnetfeldes in der Grösse von ca. 20 kOe senkrecht zur Schicht 2 Zylinderdomänen 3 erzeugt wurden. Die Magnetisierung der Schicht ist durch Pfeile 4 angedeutet.

Ausführungsbeispiel I

Als Beispiel zur Herstellung eines unmagnetischen hexagonalen Substrateinkristalls, der zur Abscheidung von monokristallinen hexagonalen Hexaferritschichten für die Herstellung einer magnetischen Anordnung (Fig. 1) geeignet ist, wird die Züchtung eines Strontium-Gallat-Einkristalls der Zusammensetzung $Sr_{1,03}Ga_{10,99}Mg_{0,49}Zr_{0,49}O_{18,99}$ beschrieben. Als Ausgangssubstanzen für die Schmelze werden 77,87 g SrO, 481,97 g $Ga_2O_3$, 9,90 g MgO und 30,26 g $ZrO_2$ gemischt, in Zylinderform verpresst und bei einer Temperatur von 1500°C in einer Sauerstoffatmosphäre gesintert. Der Sinterkörper wird anschliessend in einem induktiv beheizten Tiegel aus Iridium bei einer Temperatur von ~ 1600°C in einer abgeschlossenen Kristallziehapparatur, wie sie für die Durchführung des Czochralski-Verfahrens bekannt ist, unter Kohlendioxidatmosphäre (Strömungsgeschwindigkeit 500 l/h) aufgeschmolzen. Als Keimkristall dient ein zylinderförmiger Einkristallstab der gleichen chemischen Verbindung wie die des herzustellenden Einkristalls.

Der Ziehprozess wird in bekannter Weise nach dem Czochralski-Verfahren durchgeführt. Die Wachstumsgeschwindigkeit beträgt 1 mm $h^{-1}$, der Keimkristall wird mit einer Rotationsgeschwindigkeit von 8 $Umin^{-1}$ gedreht. Nach diesem Verfahren wurden $Sr_{1,03}Ga_{10,99}Mg_{0,49}Zr_{0,49}O_{18,99}$-Einkristalle einer Länge von 65 mm und eines Durchmessers von 30 mm hergestellt. Die Gitterkonstante beträgt in $a_o$ = 0,582 nm und in $c_o$ = 2,307 nm (a und c = kristallographische Richtungen im hexagonalen Gitter). Als Vergleich hierzu: die Gitterkonstante von $BaFe_{12}O_{19}$ beträgt in $a_o$ = 0,589 nm, in $c_o$ = 2,320 nm.

Ausführungsbeispiel II

Es wird die Züchtung eines $Sr_{1,0}Ga_{10,38}Zn_{0,81}Zr_{0,81}O_{19}$-Einkristalls beschrieben:
Als Ausgangssubstanzen werden gemischt, in Zylinderform gepresst und bei 1500°C in einer Sauerstoffatmosphäre gesintert:

| | |
|---|---|
| $SrCO_3$ | 19,28 g |
| $Ga_2O_3$ | 112,39 g |
| ZnO | 9,79 g |
| $ZrO_2$ | 14,84 g |

Die Sinterkörper werden anschliessend in einem induktiv beheizten Tiegel aus Platin oder Iridium bei einer Temperatur von ~1600°C in einer abgeschlossenen Kristallziehapparatur, wie sie für die Durchführung des Czochralski-Verfahrens verwendet wird, aufgeschmolzen. In der Apparatur befindet sich Sauerstoff unter einem Druck von 1 bar und Stickstoff unter einem Druck von 5 bar. Als Impfkristall dient ein zylinderförmiger Einkristallstab der gleichen chemischen Verbindung wie die des zu züchtenden Einkristalls. Der Ziehprozess wird in bekannter Weise nach dem Czochralski-Verfahren durchgeführt. Die Wachstumsgeschwindigkeit beträgt 2 mm $h^{-1}$, die Rotationsgeschwindigkeit des Impfkristalls 20 $Umin^{-1}$. Es wurden Kristalle der Länge von 23,5 mm und eines Durchmessers von10 mm gezüchtet. Die Gitterkonstante beträgt in $a_o$ = 0,583 nm, in $c_o$ = 2,324 nm.

Alle gezüchteten Kristalle, sowohl nach Ausführungsbeispiel I als auch nach Ausführungsbeispiel II, waren farblos und optisch transparent. Die Kristallperfektion wurde mit einem Polarisationsmikroskop und nach der Schlierenmethode untersucht. Versetzungen und Einschlüsse wurden ermittelt zu $< 1 \cdot 10^2/cm^2$.

Es ist in diesen Beispielen die Herstellung von Strontium-Gallat-Einkristallen, bei denen ein Teil der Galliumionen durch Magnesium- und Zirkoniumionen oder durch Zink- und Zirkoniumionen ersetzt sind, beschrieben. Aufgrund sehr ähnlicher Ionenradien können jedoch statt Magnesium oder Zink auch Mangan oder Eisen oder Kupfer oder Nickel oder Kobalt oder Chrom und anstelle von Zirkonium können Hafnium oder Titan oder Zinn eingesetzt werden.

Zur Realisierung einer magnetischen Anordnung zur Anwendung als Bauelement im Mikrowellenbereich oder als magnetische Zylinderdomänenanordnung werden von den wie oben beschrieben gezüchteten Einkristallen in [0001]-Richtung orientierte Substratscheiben einer Dikke von 0,5 mm bis 1 mm geschnitten, die in Richtung der c-Achse eine Abweichung von der idealen Richtung in der Grössenordnung von 1 bis 2° haben. Die Substratscheiben werden poliert. Auf diese Substratscheiben wird mit Hilfe vorzugsweise eines Flüssigphasenepitaxieverfahrens (LPE) eine bis maximal 10 µm dicke magnetische hexagonale monokristalline Hexaferritschicht, vorzugsweise eine Barium-Hexaferritschicht aufgebracht. Es kann jedoch auch eine Abscheidung aus der Gasphase (CVD) für das Aufbringen der Schicht in Betracht gezogen werden.

Der Aufwachsprozess erfolgt nach dem im wesentlichen von S.L. Blank und J.W. Nielsen in J. of Cryst. Growth 17 (1972), S. 302-311 beschriebenen LPE-Verfahren, es wird jedoch eine wesentlich höhere Konzentration an auszukristallisierendem Ferritmaterial eingesetzt.

Die Schmelze, aus der die Ferritschichten aufwachsen, hat folgende Zusammensetzung (Angaben in Gew. %):

| | |
|---|---|
| PbO | 76,99 |
| $B_2O_3$ | 1,91 |
| BaO | 2,71 |
| $Fe_2O_3$ | 16,90 |
| $Ga_2O_3$ | 0,99 |
| $Al_2O_3$ | 0,50 |
| | 100,00 |

Die Ausgangssubstanzen werden bei 1100°C in einem Platintiegel aufgeschmolzen und mehrere Stunden mit einem Rührer aus Platin gerührt, um die schmelzflüssige Lösung zu homogenisieren.

Die Sättigungstemperatur der angegebenen Zusammensetzung liegt bei ca. 995°C. Die Schmelze wird auf 975°C abgekühlt und die Temperatur konstant gehalten; es hanndelt sich hier um einen isothermen Aufwachsprozess. Das in

einem Platinhalter befestigte Substrat wird in die Schmelze getaucht, in bekannter Weise je nach Wachstumsbedingungen in vertikaler oder horizontaler Stellung mit oder ohne Drehbewegung. Bei der angegebenen Schmelzzusammensetzung kristallisiert in 90 sec bei vertikaler Anordnung ohne Rotation des Substrates eine ~4 μm dicke Schicht aus. Die chemische Analyse der Schicht mit Hilfe einer Mikrosonde ergab einen Bleigehalt von ~6 Gew.% PbO, bedingt durch die Schmelzzusammensetzung und die Wachstumsparameter. Aus chemischer Analyse, Gitterkonstantenbestimmung und Messung des Anisotropiefeldes der Schicht bei 60 - 90 GHz folgt, dass es sich um Bariumhexaferrit $Ba(Pb)Fe_{12}O_{19}$ mit Magnetoplumbitstruktur handelt. Die Sättigungsmagnetisierung ($4\pi\ M_s$) des Schichtmaterials wurde zu ~4000 Gauss bestimmt. Der Unterschied der Gitterkonstanten von Schicht und Substrat, die Fehlanpassung, wird röntgenografisch beim 0028 Reflex gemessen. Durch Zuwaage von Gallium oder Aluminium zur Schmelze kann die Gitterkonstante der Schicht gemäss fachmännischem Handeln an die des Substrates angepasst werden. Bei Bariumhexaferrit $Ba(Pb)Fe_{12}O_{19}$ liegt die Fehlanpassung bei -0,013 nm, durch Einbau von Gallium- oder Aluminiumionen wird sie auf -0,007 nm verringert.

Magnetische Domänenstrukturen (Fig. 1, Bezugszeichen 3) wurden in der nach dem oben beschriebenen Verfahren hergestellten Schicht sichtbar gemacht, dabei ist jedoch auf folgendes zu achten:

Durch die Doppelbrechung der Substrate wird der Polarisationseffekt ausgelöscht, d.h. die infolge der Faradaydrehung sonst sichtbaren Weissschen Bezirke sind nicht sichtbar. Bei abgeplatzten Schichten jedoch, bei denen die Doppelbrechung des Substrats die Faradaydrehung und den Polarisationseffekt nicht auslöschen kann, sind Domänen gut zu erkennen. Durch Anlegen eines Magnetfeldes senkrecht zur Schicht in einer Grösse von ca. 20 kOe wurde aus in dieser Schicht vorhandenen Streifendomänen ein Zylinderdomänenmuster erzeugt und photographiert. Die Grösse, d.h. der Durchmesser der Zylinderdomänen hängt von der Schichtdicke der magnetischen Schicht ab., durch Verringerung der Schichtdicke auf unter 1 μm werden die Zylinderdomänen im Durchmesser ebenfalls kleiner als 1 μm, sie sind dann allerdings nicht mehr im Lichtmikroskop abzubilden, da die Wellenlänge des Lichtes hier die Grenze bildet. Dieses Phänomen wurde beschrieben in der Arbeit von F. Haberey, G. Oehlschlegel, K. Sahl in «Berichte der Deutschen Keramischen Gesellschaft» 54 (1977), Nr. 11, S. 373-378.

Bauelemente für Zylinderdomänenanwendungen können aus den wie oben beschrieben hergestellten, mit einer monokristallinen Bariumhexaferritschicht versehenen Substraten gemäss bekannten Techniken, wie z.B. von A.H. Bobeck, P.I. Bonyhard, J.E. Geusic in Proc. I.E.E.E. 63 (1975), Nr. 8, S. 1176-1195 beschrieben, hergestellt werden.

**Patentansprüche**

1. Magnetische Anordnung mit einem monokristallinen, nichtmagnetischen Substrat. das eine zum Niederschlagen einer Schicht bestimmte Oberfläche hat und mit einer monokristallinen, magnetischen Schicht aus hexagonalem Hexaferritmaterial, dadurch gekennzeichnet, dass das Substrat aus einem Erdalkali-Gallat-Mischkristall der allgemeinen Formel

$$A^{2+}_{1+y}Ga_{12-2x-y}B^{2+}_xC^{4+}_xO_{19}$$

besteht, wobei in der Formel bedeuten:
A = Barium und/oder Strontium
B = Magnesium und/oder Mangan und/oder Zink und/oder Eisen und/oder Kupfer und/oder Nickel und/oder Kobalt und/oder Chrom
C = Zirkonium und/oder Hafnium und/oder Titan und/oder Zinn
und $0{,}1 \leqq x \leqq 1{,}2$ und $0 \leqq y \leqq 0{,}8$.

2. Magnetische Anordnung nach Anspruch 1, dadurch gekennzeichnet, dass in der Formel bedeutet:
$0{,}4 \leqq x \leqq 0{,}8$.

3. Magnetische Anordnung nach einem der Ansprüche 1 oder 2, dadurch gekennzeichnet, dass das Substrat eine Zusammensetzung gemäss der Formel $Sr_{1,03}Ga_{10,99}Mg_{0,49}Zr_{0,49}O_{18,99}$ hat.

4. Magnetische Anordnung nach Anspruch 1, dadurch gekennzeichnet, das das Substrat eine Zusammensetzung gemäss der Formel $Sr_{1,0}Ga_{10,38}Zn_{0,81}Zr_{0,81}O_{19}$ hat.

5. Magnetische Anordnung nach einem der vorgehenden Ansprüche, dadurch gekennzeichnet, dass die zum Niederschlagen einer Schicht bestimmte Oberfläche des Substrates eine Orientierung in [0001]-Richtung hat und eine Abweichung von der idealen Richtung der c-Achse im Bereich von 1 bis 2° aufweist.

6. Magnetische Anordnung nach Anspruch 1, dadurch gekennzeichnet, dass das Material der magnetischen Schicht ein Erdalkalihexaferrit ist.

7. Magnetische Anordnung nach Anspruch 6, dadurch gekennzeichnet, dass das Material der magnetischen Schicht Bariumhexaferrit der Formel $Ba(Pb)\ Fe_{12}O_{19}$ ist.

8. Magnetische Anordnung nach einem der vorhergehenden Ansprüche, dadurch gekennzeichnet,dass die Schichtdicke der magnetischen Schicht im Bereich von 0,5 bis 10 μm liegt.

9. Hexagonaler Mischkristall der allgemeinen Formel

$$A^{2+}_{1+y}Ga_{12-2x-y}B^{2+}_xC^{4+}_xO_{19}$$

worin sind:

A = Barium und/oder Strontium
B = Magnesium und/oder Mangan und/oder Zink und/oder Eisen und/oder Kupfer und/oder Nickel und/oder Kobalt und/oder Chrom

C = Zirkonium und/oder Hafnium und/oder Titan und/oder Zinn

$0,1 \leqslant x \leqslant 1,2$ und $0 \leqslant y \leqslant 0,8$.

10. Hexagonaler Mischkristall nach Anspruch 9, dadurch gekennzeichnet, dass $0,4 \leqslant x \leqslant 0,8$ ist.

11. Hexagonaler Mischkristall nach Anspruch 9, dadurch gekennzeichnet, dass seine Zusammensetzung der Formel $Sr_{1,03}Ga_{10,99}Mg_{0,49}Zr_{0,49}O_{18,99}$ entspricht.

12. Hexagonaler Mischkristall nach Anspruch 9, dadurch gekennzeichnet, dass seine Zusammensetzung der Formel $Sr_{1,0}Ga_{10,38}Zn_{0,81}Zr_{0,81}O_{19}$ entspricht.

13. Verfahren zur Herstellung eines hexagonalen Mischkristalls gemäss den Ansprüchen 9 bis 12, dadurch gekennzeichnet, dass die Ausgangssubstanzen für den Substrateinkristall zunächst trocken verpresst und in einer Sauerstoffatmosphäre gesintert werden, dass der Sinterkörper zur Herstellung eines Einkristalls nach dem Czochralski-Verfahren in einer abgeschlossenen Kristallziehapparatur aufgeschmolzen und dass aus dieser Schmelze ein Einkristall mit Hilfe eines Keimkristalls gezogen wird, und dass von diesem Einkristall Scheiben mit einer Orientierung die von 1 bis 2° von der idealen Richtung der c-Achse abweicht, abgeschnitten und poliert werden.

14. Verfahren nach Anspruch 13, dadurch gekennzeichnet, dass die Ausgangssubstanzen $G_2O_3$, SrO, MgO, $ZrO_2$ unter $CO_2$-Atmosphäre in einer abgeschlossenen Kristallziehapparatur erschmolzen werden.

15. Verfahren nach Anspruch 13, dadurch gekennzeichnet, dass die Ausgangssubstanzen $SrCO_3$, $Ga_2O_3$, ZnO und $ZrO_2$ unter einem Druck von 1 bar $O_2$ und 5 bar $N_2$ in einer abgeschlossenen Kristallziehapparatur erschmolzen werden.

16. Verwendung der magnetischen Anordnung nach einem der Ansprüche 1 bis 8 als Bauelement für den Mikrowellenbereich.

17. Verwendung der magnetischen Anordnung nach einem der Ansprüche 1 bis 8 in magnetischen Zylinderdomänenanordnungen.

## Revendications

1. Dispositif magnétique muni d'un substrat non magnétique monocristallin, présentant une surface destinée au dépôt d'une couche,et d'une couche magnétique monocristalline en matériau d'hexaferrite hexagonale, caractérisé en ce que le substrat est constitué par un cristal mixte de gallate-alcalino-terreux répondant à la formule générale

$$A^{2+}_{1+y}Ga_{12-2x-y}B^{2+}_{x}C^{4+}_{x}O_{19}$$

dans laquelle

A = du baryum et/ou du strontium

B = du magnésium et/ou du manganèse et/ou du zinc et/ou du fer et/ou du cuivre et/ou du nickel et/ou du cobalt et/ou du chrome

C = du zirconium et/ou de l'hafnium et/ou du titane et/ou de l'étain

et $0,1 \leqq x \leqq 1,2$ et $0 \leqq y \leqq 0,8$.

2. Dispositif magnétique selon la revendication 1, caractérisé en ce que la formule: $0,4 \leqq x \leqq 0,8$.

3. Dispositif magnétique selon l'une des revendications 1 ou 2, caractérisé en ce que le substrat présente une composition répondant à la formule $Sr_{1,03}Ga_{10,99}Mg_{0,49}Zr_{0,49}O_{18,99}$.

4. Dispositif magnétique selon la revendication 1, caractérisé en ce que le substrat présente une composition répondant à la formule $Sr_{1,0}Ga_{10,38}Zn_{0,81}Zr_{0,81}O_{19}$.

5. Dispositif magnétique selon l'une des revendications précédentes, caractérisé en ce que la surface du substrat destinée au dépôt d'une couche présente une orientation dans la direction [0001] et un écart de la direction idéale de l'axe c dans la gamme de 1 à 2°.

6. Dispositif magnétique selon la revendication 1, caractérisé en ce que le matériau de la couche magnétique est de l'hexaferrite alcalino-terreux.

7. Dispositif magnétique selon la revendication 6, caractérisé en ce que le matériau de la couche magnétique est de l'hexaferrite de baryum répondant à la formule $Ba(Pb)Fe_{12}O_{19}$.

8. Dispositif magnétique selon l'une des revendications précédentes, caractériseé en ce que l'épaisseur de couche de la couche magnétique se situe entre 0,5 à 10 µm.

9. Cristal mixte hexagonal répondant à la formule générale

$$A^{2+}_{1+y}Ga_{12-2x-y}B^{2+}_{x}C^{4+}_{x}O_{19}$$

dans laquelle

A = du baryum et/ou du strontium

B = du magnésium et/ou du manganèse et/ou du zinc et/ou du fer et/ou du cuivre et/ou du nickel et/ou du cobalt et/ou du chrome

C = du zirconium et/ou de l'hafnium et/ou du titane et/ou de l'étain

$0,1 \leqslant x \leqslant 1,2$ et $0 \leqslant y \leqslant 0,8$.

10. Cristal mixte hexagonal selon la revendication 9, caractérisé en ce que $0,4 \leqslant x \leqslant 0,8$.

11. Cristal mixte hexagonal selon la revendication 9, caractérisé en ce que sa composition répond à la formule $Sr_{1,03}Ga_{10,99}Mg_{0,49}Zr_{0,49}O_{18,99}$.

12. Cristal mixte hexagonal selon la revendication 9, caractérisé en que sa composition répond à la formule $Sr_{1,0}Ga_{10,38}Zn_{0,81}Zr_{0,81}O_{19}$.

13. Procédé pour la réalisation d'un cristal mixte hexagonal selon les revendications 9 à 12, caractérisé en ce que les substances de départ pour le substrat monocristallin sont d'abord comprimées à l'état sec et frittées dans une atmosphère d'oxygène, que le corps fritté est d'abord scellé dans un appareil de tirage de cristaux fermé pour la réalisation d'un monocristal selon le processus de Czochralski et qu'un monocristal est tiré de ce bain à l'aide d'un cristal de germination, et qu'à partir de ce monocristal sont coupés des disques

présentant une orientation qui s'écarte de 1 à 2° de la direction idéale de l'axe c et ensuite polis.

14. Procédé selon la revendication 13, caractérisé en ce que les substances de départ $Ga_2O_3$, SrO, MgO, $ZrO_2$ sont fondues dans une atmosphère de $CO_2$ dans un appareil de tirage de cristaux fermé.

15. Procédé selon la revendication 13, caractérisé en ce que les substances de départ $SrCO_3$, $Ga_2O_3$, ZnO et $ZrO_2$ sont fondues sous une pression de 1 bar de $O_2$ et 5 bar de $N_2$ dans un appareil de tirage de cristaux fermé.

16. Application du dispositif magnétique selon l'une des revendications 1 à 8 comme composant pour la gamme de micro-onde.

17. Application du dispositif magnétique selon l'une des revendications 1 à 8 dans des dispositifs à domaines cylindriques magnétiques.

**Claims**

1. Magnetic device with a monocrystalline, nonmagnetic substrate, which has a surface adapted for the deposition of a layer and bearing a monocrystalline, magnetic layer of hexagonal hexaferrite material, characterized in that the substrate consists of an alkaline earth gallate mixed crystal with the general formula

$$A^{2+}_{1+y}Ga_{12-2x-y}B^{2+}_{x}C^{4+}_{x}O_{19}$$

where the symbols in the formula mean:
A = barium and/or strontium
B = magnesium and/or manganese and/or zinc and/or iron and/or copper and/or nickel and/or cobalt and/or chromium
C = zirconium and/or hafnium and/or titanium and/or tin
and $0.1 \leqslant x \leqslant 1.2$ and $0 \leqslant y \leqslant 0.8$.

2. Magnetic device as claimed in Claim 1, characterized in that $0.4 \leqslant x \leqslant 0.8$.

3. Magnetic device as described in Claim 1 or 2, characterized in that the substrate has a composition in accordance with the formula $Sr_{1.03}Ga_{10.99}Mg_{0.49}Zr_{0.49}O_{18.99}$.

4. Magnetic device as claimed in Claim 1, characterized in that the substrate has a composition in accordance with the formula $Sr_{1.0}Ga_{10.38}Zn_{0.81}Zr_{0.81}O_{19}$.

5. Magnetic device as claimed in one of the previous claims, characterized in that the surface of the substrate intended for the deposition of a layer has an orientation in the [0001] direction and a deviation in the range of 1 to 2° from the ideal direction of the c-axis.

6. Magnetic device as claimed in Claim 1, characterized in that the material of the magnetic layer is an alkaline earth hexaferrite.

7. Magnetic device as claimed in Claim 6, characterized in that the material of the magnetic layer is barium hexaferrite with the formula Ba(Pb) $Fe_{12}O_{19}$.

8. Magnetic device as claimed in one of the previous claims, characterized in that the layer thickness of the magnetic layer lies in the range of 0.5 to 10 µm.

9. Hexagonal mixed crystal with the general formula:

$$A^{2+}_{1+y}Ga_{12-2x-y}B^{2+}_{x}C^{4+}_{x}O_{19}$$

in which:
A = barium and/or strontium
B = magnesium and/or manganese and/or zinc and/or iron and/or copper and/or nickel and/or cobalt and/or chromium
C = zirconium and/or hafnium and/or titanium and/or tin
$0.1 \leqslant x \leqslant 1.2$ and $0 \leqslant y \leqslant 0.8$.

10. Hexagonal mixed crystal as claimed in Claim 9, characterized in that $0.4 \leqslant x \leqslant 0.8$.

11. Hexagonal mixed crystal as claimed in Claim 9, characterized in that its composition corresponds to the formula $Sr_{1.03}Ga_{10.99}Mg_{0.49}Zr_{0.49}O_{18.99}$.

12. Hexagonal mixed crystal as claimed in Claim 9, characterized in that its composition corresponds to the formula $Sr_{1.0}Ga_{10.38}Zn_{0.81}Zr_{0.81}O_{19}$.

13. Process for the production of a hexagonal mixed crystal as claimed in one of the Claims 9 to 12, characterized in that the starting substances for the monocrystalline substrate are first dry-pressed and sintered in an oxygen atmosphere, the sintered body for the production of a monocrystal is melted in a closed crystal pulling apparatus according to the Czochralski process and a monocrystal is pulled from this melt with the aid of a seed crystal, and slices with an orientation which deviates by 1 to 2° from the ideal direction of the c-axis are cut and polished from this monocrystal.

14. Process as claimed in Claim 13, characterized in that the starting substances $Ga_2O_3$, SrO, MgO and $ZrO_2$ are melted in a closed crystal pulling apparatus in a $CO_2$ atmosphere.

15. Process as claimed in Claim 13, characterized in that the starting substances $SrCO_3$, $Ga_2O_3$, ZnO, and $ZrO_2$ are melted in a closed crystal pulling apparatus under a pressure of 1 bar $O_2$ and 5 bar $N_2$.

16. Use of the magnetic device as claimed in one of the Claims 1 to 8 as a microwave component.

17. Use of the magnetic device as claimed in one of the Claims 1 to 8 in magnetic cylindrical domain devices.

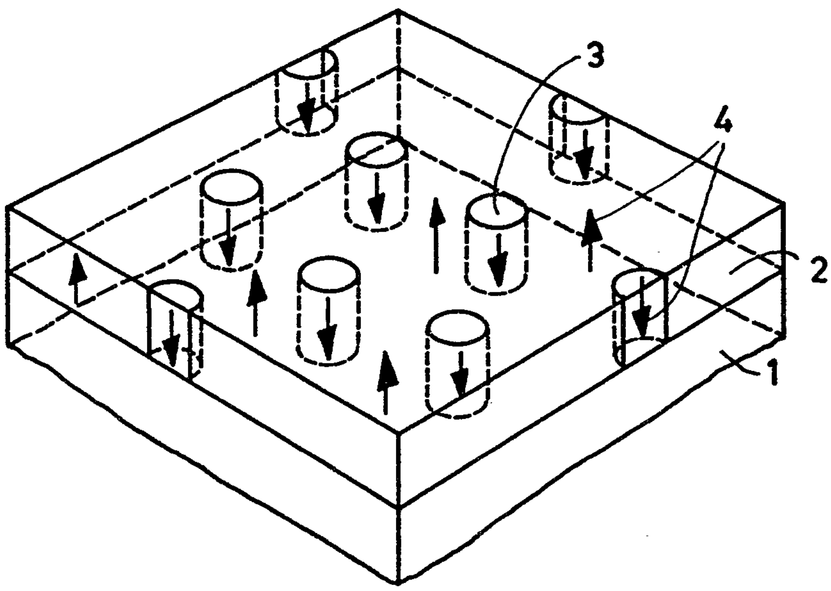
3
4
2
1